Europäisches Patentamt

European Patent Office

Office européen des brevets

(19)

(11) EP 0 587 937 B1

(12) **EUROPÄISCHE PATENTSCHRIFT**

(45) Veröffentlichungstag und Bekanntmachung des Hinweises auf die Patenterteilung:
**20.11.1996 Patentblatt 1996/47**

(51) Int Cl.⁶: **H03K 19/003**, H03K 19/0185, H03K 3/353

(21) Anmeldenummer: **92116034.7**

(22) Anmeldetag: **18.09.1992**

(54) **Integrierte Pufferschaltung**

Integrated buffer circuit

Circuit tampon integré

(84) Benannte Vertragsstaaten:
**AT DE FR GB IE IT NL**

(43) Veröffentlichungstag der Anmeldung:
**23.03.1994 Patentblatt 1994/12**

(73) Patentinhaber: **SIEMENS AKTIENGESELLSCHAFT**
**80333 München (DE)**

(72) Erfinder:
- **Murphy, Brian, B. Sc.**
  **W-8345 Brombach (DE)**
- **Zibert, Martin, Dipl.-Ing.**
  **W-8206 Heufeld (DE)**

(56) Entgegenhaltungen:
EP-A- 0 397 268      EP-A- 0 437 039
JP-A- 3 190 421      JP-A- 4 134 923
US-A- 4 086 500      US-A- 5 101 119
US-A- 5 268 599

- **PATENT ABSTRACTS OF JAPAN vol. 14, no. 476 (E-991) 17. Oktober 1990 & JP-A-21 95 718**

**Beschreibung**

Die Erfindung betrifft eine integrierte Pufferschaltung nach dem Oberbegriff des Patentanspruches 1.

Pufferschaltungen werden in integrierten Schaltkreisen häufig benötigt, beispielsweise um Eingangssignale der Schaltkreise an schaltkreis-intern geforderte Signaleigenschaften (z.B. Pegel) anzupassen oder um Ausgangssignale von Schaltungen an nachfolgende, weitere Schaltungen anzupassen. Nachteilig bei Pufferschaltungen ist bekanntlich ihre Empfindlichkeit gegenüber Störungen (z.B. Rauschen) auf den Leitungen für die Versorgungsspannung. Ihre Funktion ist weiterhin stark abhängig von bei der Versorgungsspannung evtl. auftretenden Spannungsschwankungen, dies insbesondere dann, wenn die Pufferschaltung Signale mit TTL-Pegeln in solche mit CMOS-Pegeln umsetzen soll (TTL-Pegel: 0 V und 2.4 V; CMOS-Pegel meist 0 V und 4 bis 6 V, typisch 5 V).

Aus "Patent Abstracts of Japan", Vol. 8, No. 53 (E-231) (1490), March 9, 1984, betreffend die JP-A 58-207 728, sowie, aus den nachveröffentlichten US-A 5,268,599, die für die am 8-5-92 veröffentlichte JP-A 4 134 923 zitiert wird, sind Pufferschaltungen mit einem Inventer und einer Konstantstromquelle bekannt. Zwar bewirkt die in diesen beiden Dokumenten vorhandene Konstantstromquelle bereits eine Verringerung der eingangs genannten Empfindlichkeit gegenüber Störungen. Aber dies geschieht nicht in dem oft gewünschten Ausmaß.

Aufgabe der vorliegenden Erfindung ist es deshalb, eine integrierte Pufferschaltung zu schaffen, die weitgehend unabhängig ist von Störungen auf ihrem Eingangssignal und auf den Leitungen für die Versorgungsspannung. Sie soll auch möglichst unempfindlich sein gegenüber Schwankungen der Versorgungsspannung. Weiterhin soll sie sowohl für Eingangssignale mit TTL-Pegeln wie auch für solche mit CMOS-Pegeln geeignet sein, wobei ihr Ausgangssignal jeweils CMOS-Pegel aufweisen soll.

Diese Aufgabe wird bei einer gattungsgemäßen integrierten Pufferschaltung gelöst mit den kennzeichnenden Merkmalen des Patentanspruches 1. Vorteilhafte Aus- und Weiterbildungen sind in Unteransprüchen gekennzeichnet.

Die Erfindung wird nachstehend anhand der Zeichnung näher erläutert. Es zeigen:

Die Figuren 1 bis 7, 11, 12       vorteilhafte Aus- und Weiterbildungen,
die Figuren 8 und 9       Potentialdiagramme
und Figur 10       ein Diagramm als Dimensionierungsbeispiel.

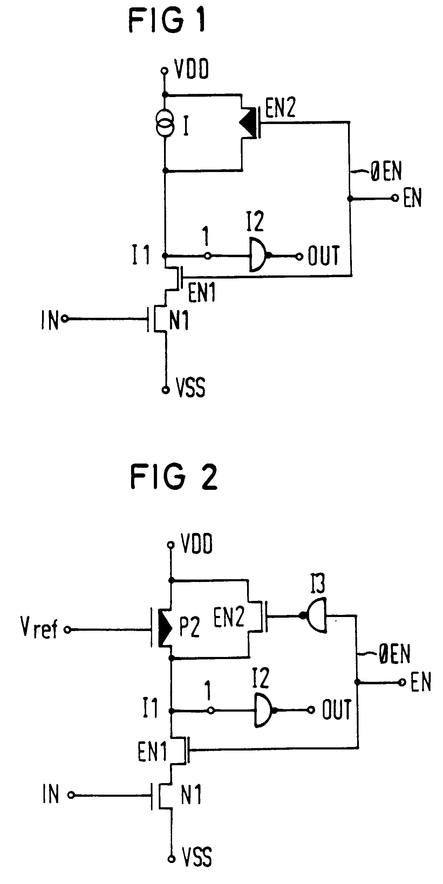

Die Ausführungsform nach Figur 1 enthält zwei hintereinandergeschaltete Inverter I1,I2. Der erste Inverter I1 enthält als funktionsbestimmende Elemente einen n-Kanal-Transistor N1 und eine Konstantstromquelle I, die in Serie zueinander zwischen ein erstes (VSS) und ein zweites Versorgungspotential VDD geschaltet sind. Im Betrieb liegt an ihm über das Gate des Transistors N1 ein Eingangssignal IN an. Dieses kann entweder TTL-Pegel aufweisen oder CMOS-Pegel. Am Ausgang des zweiten Inverters I2, der vorzugsweise ein CMOS-Inverter ist, entsteht im Betrieb ein Ausgangssignal OUT der Pufferschaltung. Die beiden Inverter I1,I2 sind über einen Schaltungsknoten 1 miteinander verbunden. Die Source des Transistors N1 des ersten Inverters I1 ist mit dem ersten Versorgungspotential VSS (meist gleich 0 V) verbunden. Die Konstantstromquelle I des ersten Inverters I1 ist einerseits mit dem zweiten Versorgungspotential VDD und andererseits mit dem Schaltungsknoten 1 verbunden.

Die Drain des Transistors N1 des ersten Inverters I1 ist über die Kanalstrecke eines ersten Enable-Transistors EN1 mit dem Schaltungsknoten 1 und somit mit der Konstantstromquelle I verbunden. Parallel zur Konstantstromquelle I ist ein zweiter Enable-Transistor EN2 mit seiner Kanalstrecke zwischen dem zweiten Versorgungspotential VDD und dem Schaltungsknoten 1 angeordnet. Die Gates der beiden Enable-Transistoren EN1, EN2 sind gemeinsam mit einem Enable-Eingang EN der Pufferschaltung verbunden. An den Enable-Eingang EN ist im Betrieb ein Enable-Signal ØEN anlegbar.

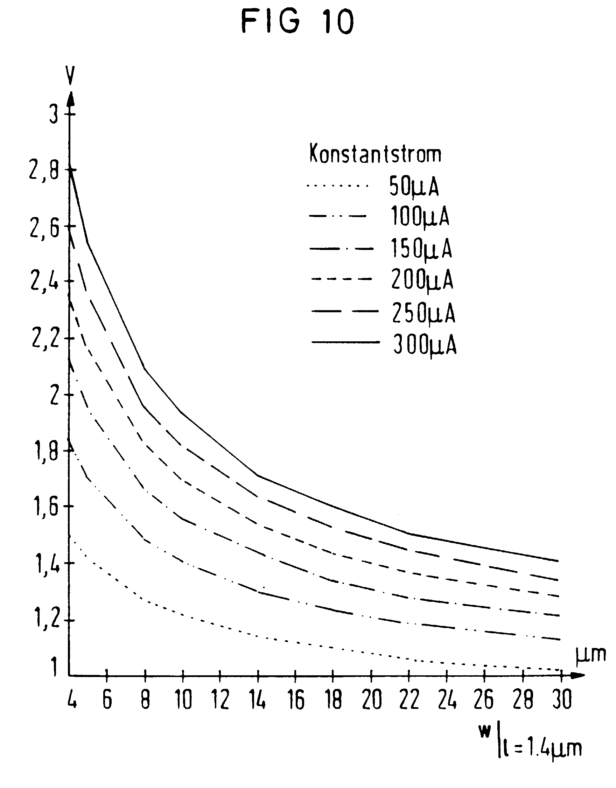

Der Umschaltpunkt des ersten Inverters I1 ist durch geeignete Dimensionierung seines Transistors N1 bei leitendem ersten Enable-Transistor EN1 und gesperrtem zweiten Enable-Transistor EN2 festgelegt in Abhängigkeit vom Wert des Stromes der Konstantstromquelle I. Figur 10 zeigt beispielhaft sich ergebende Umschaltpunkte (Ordinate, Maßeinheit: Volt) bei Variation der Kanalweite des Transistors N1 (Abszisse, Maßeinheit: µm), wobei verschiedene Stromstärken der Konstantstromquelle I (Maßeinheit: µA) als Parameter angegeben sind und wobei die Kanallänge des Transistor N1 stets als konstant mit 1,4 µm angenommen ist.

Bei leitendem ersten Enable-Transistor EN1 und gesperrtem zweiten Enable-Transistor EN2 ist wegen der so erfolgten Verbindung des Transistors N1 des ersten Inverters I1 mit der Konstantstromquelle I der Umschaltpunkt in sehr engen Grenzen festgelegt, daher ist die Pufferschaltung sehr unempfindlich gegen Störungen und Spannungsschwankungen des zweiten Versorgungspotentials VDD, das der Konstantstromquelle I als Versorgungsquelle dient. Wegen der Festlegung des Umschaltpunktes des ersten Inverters I1 in sehr engen Grenzen ist die Pufferschaltung gleichfalls unempfindlich gegen Störungen am Eingangssignal IN.

Zu einer weiteren Verringerung der Empfindlichkeit gegen Störungen tragen die beiden Enable-Transistoren EN1, EN2 mittels des Enable-Signals ØEN bei: Das Enable-Signal ØEN weist normalerweise einen aktivierten, ersten logischen Pegel auf (in der Ausführungsform nach Figur 1, bei der erste Enable-Transistor EN1 vom n-Kanal-Typ ist und bei der der zweite Enable-Transistor EN2 vom p-Kanal-Typ ist, ist dies ein High-Pegel), bei dem der erste Enable-Transistor EN1 elektrisch leitend geschaltet ist und bei dem der zweite Enable-Transistor EN2 elektrisch sperrt. In diesem Fall liegt am Schaltungsknoten 1 ein durch das Eingangssignal IN und die Dimensionierung des ersten Inverters I1 sowie die Dimensionierung der Konstantstromquelle I bestimmtes Signal an, welches mittels des zweiten Inverters I2 als Ausgangssignal OUT an den Ausgang der Pufferschaltung gelangt.

Wenn nun bekannt ist, daß zu bestimmten Zeitpunkten besonders intensive Störungen zu erwarten sind (beispielsweise bei einem die erfindungsgemäße Pufferschaltung enthaltenden integrierten Halbleiterspeicher mit Adreßmultiplexeinrichtung, welche durch eine Adreßübernahmesignal $\overline{RAS}$ gesteuert ist, verursacht dieses Adreßübernahmesignal $\overline{RAS}$ bei Wechsel seines Pegelzustandes besonders große Störungen auf dem Halbleiterchip), so kann das Enable-Signal ØEN mit einem solchen zeitlichen Verlauf an den Enable-Eingang EN angelegt werden, daß es zu Zeitpunkten, zu denen solche Störungen zu erwarten sind, einen inaktivierten, zweiten logischen Pegel aufweist (in der Ausführungsform nach Figur 1 ist dies ein Low-Pegel), während es ansonsten den aktivierten, ersten logischen Pegel aufweist. Bei inaktiviertem Pegel ist dann der erste Enable-Transistor EN1 unabhängig vom Eingangssignal IN der Pufferschaltung elektrisch gesperrt, während der zweite Enable-Transistor EN2 elektrisch leitend geschaltet ist, so daß die Wirkungen der Konstantstromquelle I und des ersten Inverters I1 aufgehoben sind. In diesem Fall stellt sich am Schaltungsknoten 1 ein Pegel ein mit dem Wert des zweiten Versorgungspotentials VDD, wodurch das Ausgangssignal OUT einen niedrigen Pegel annimmt. Dabei ist angenommen, daß durch den niedrigen Pegel des Ausgangssignals OUT der Pufferschaltung nachgeschaltete, sonstige Schaltungsteile eines integrierten Schaltkreises, welcher die erfindungsgemäße Pufferschaltung enthält, inaktiv geschaltet sind.

Figur 2 zeigt eine vorteilhafte Ausgestaltung der Ausführungsform von Figur 1. Die in Figur 1 gezeigte Konstantstromquelle I enthält nach Figur 2 einen MOS-Transistor P2 vom p-Kanal-Typ. Er ist mit seiner Kanalstrecke zwischen dem Schaltungsknoten 1 des ersten Inverters I1 und dem zweiten Versorgungspotential VDD angeordnet. An seinem Gate liegt im Betrieb ein Referenzpotential $V_{ref}$ an, das einen bezüglich des Wertes des zweiten Versorgungspotentials VDD konstanten Wert aufweist. Verringert sich der Wert des zweiten Versorgungspotentials VDD im Betrieb um einen Betrag $\Delta$VDD, so verringert sich das Referenzpotential $V_{ref}$ um denselben Betrag $\Delta$VDD. Erhöht sich der Wert des zweiten Versorgungspotentials VDD im Betrieb um einen Betrag $\Delta$VDD, so erhöht sich das Referenzpotential $V_{ref}$ um denselben Betrag $\Delta$VDD. Der Wert des Referenzpotentials $V_{ref}$ ist so bemessen, daß der MOS-Transistor P2 bei gesperrtem zweiten Enable-Transistor EN2 elektrisch leitend ist. Die Spannung $U_{GS}$ zwischen Gate und Source des MOS-Transistors P2 ist, entsprechend dem oben Gesagten, konstant. Deshalb fließt im Betrieb ein konstanter Strom $I_{DS}$ über die Kanalstrecke des MOS-Transistors P2; dieser wirkt also als Konstantstromquelle I.

Figur 2 zeigt auch eine weitere Ausführungsform der Enable-Transistoren EN1, EN2: Während in der Ausführungsform nach Figur 1 die Enable-Transistoren EN1, EN2 vom zueinander entgegengesetzten Kanaltyp sind (erster Enable-Transistor EN1: n-Kanal-Typ, zweiter Enable-Transistor EN2: p-Kanal-Typ), sind sie in der Ausführungsform nach Figur 2 vom selben Kanaltyp, nämlich vom n-Kanal-Typ. Zwischen dem Enable-Eingang EN und dem Gate des zweiten Enable-Transistors EN2 ist des weiteren ein dritter Inverter I3 angeordnet, so daß der zweite Enable-Transistor EN2 nach Figur 2 dasselbe Schaltverhalten aufweist hinsichtlich des Enable-Signals ØEN wie der zweite Enable-Transistor EN2 nach Figur 1.

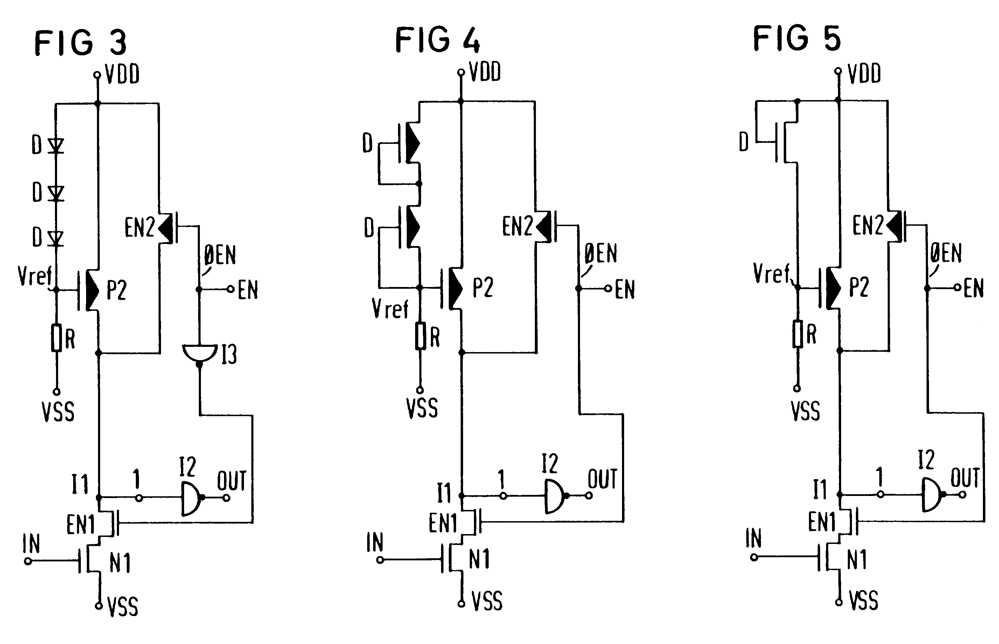

Die Ausführungsform nach Figur 3 zeigt eine Ausgestaltung entsprechend Figur 2, allerdings ergänzt um eine Einrichtung zum Erzeugen des Referenzpotentials $V_{ref}$ und mit Enable-Transistoren EN1, EN2 vom p-Kanal-Typ. Wegen des im Vergleich zu den Enable-Transistoren EN1, EN2 nach Figur 2 entgegengesetzten Schaltverhaltens der Enable-Transistoren EN1, EN2 nach Figur 3 ist der bezüglich Figur 2 genannte dritte Inverter I3 in Figur 3 zwischen dem Enable-Eingang EN und dem Gate des ersten Enable-Transistors EN1 angeordnet. Die Einrichtung zum Erzeugen des Referenzpotentials $V_{ref}$ nach Figur 3 enthält drei in Serie zueinander geschaltete Dioden D (erfindungsgemäß ist mindestens eine Diode vorgesehen), die zwischen dem zweiten Versorgungspotential VDD und dem Gate des MOS-Transistors P2 angeordnet sind, und einen Widerstand R, der zwischen dem Gate des MOS-Transistors P2 und dem ersten Versorgungspotential VSS angeordnet ist. Der Widerstand R kann selbstverständlich durch ein Widerstandsnetzwerk mit mehreren (in Serie und/oder parallel-geschalteten) Widerständen ersetzt sein. Der Widerstand R ist so dimensioniert (z.B. 250 kOhm), daß im eingeschwungenen Zustand bezüglich des Eingangssignales IN und bei aktiviertem, erstem logischen Pegel des Enable-Signals ØEN ein möglichst geringer Strom zwischen dem zweiten Versorgungspotential VDD und dem ersten Versorgungspotential VSS (über die Dioden D) fließt. Er kann beispielsweise als Implantationswiderstand oder in Form einer hochohmigen Polysiliziumleitung oder als MOS-Transistor mit hohem Kanalwiderstand realisiert sein. Auf diese Weise weist das Referenzpotential $V_{ref}$ stets dieselbe Differenz zum zweiten Versorgungspotential VDD auf, nämlich die Summe $\Sigma V_{thD}$ der Diodenflußspannungen $V_{thD}$ der einzelnen Dioden D. Die Dioden D sind in der Ausführungsform nach Figur 3 pn-Übergangsdioden.

In der Ausführungsform nach Figur 4 sind die Dioden D als Dioden geschaltete Transistoren (gezeigt sind, im Unterschied zu Figur 3, lediglich zwei Dioden D) vom p-Kanal-Typ. Weiterhin sind die Enable-Transistoren EN1, EN2 vom entgegengesetzten Kanaltyp entsprechend der Ausführungsform nach Figur 1.

Figur 5 zeigt, anstelle der drei Dioden D nach Figur 3 bzw. anstelle der zwei Dioden D nach Figur 4, eine einzige Diode D in Gestalt eines als Diode geschalteten Transistors vom n-Kanal-Typ.

Für eine Realisierung der erfindungsgemäßen Pufferschaltung innerhalb einer integrierten Halbleiterschaltung ist es besonders günstig, die Dioden D in Gestalt von als Dioden geschalteten p-Kanal-Transistoren zu realisieren. Dies hat gegenüber den beiden anderen Ausführungsformen (n-Kanal-Transistoren als Dioden bzw. pn-Übergangsdioden) den Vorteil, daß herstellungsbedingte Schwankungen im MOS-Transistor P2 (Technologieschwankungen und Temperaturabhängigkeit) durch die als Dioden D geschalteten p-Kanal-Transistoren automatisch, herstellungsbedingt ausgeglichen werden.

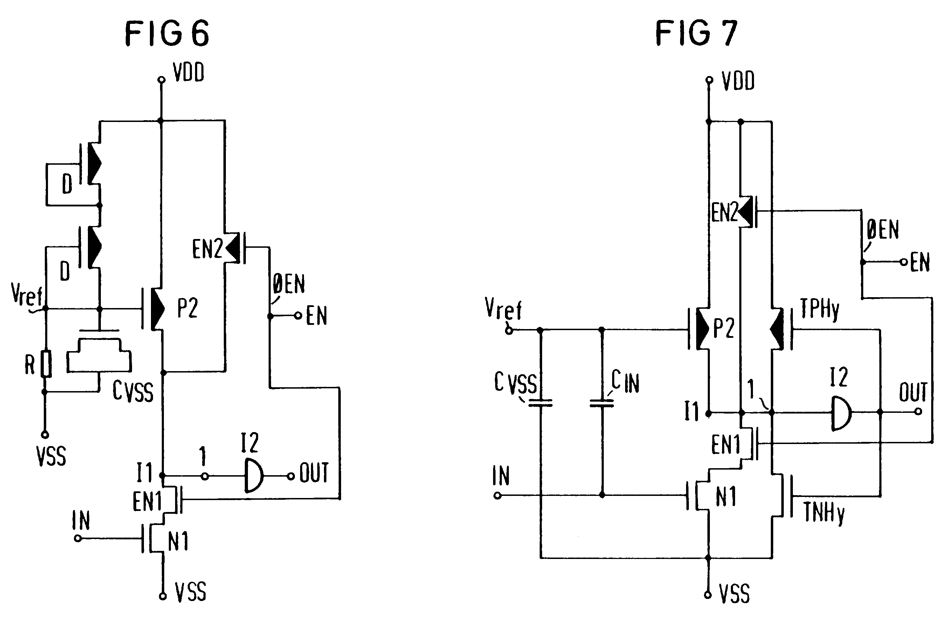

Die Weiterbildung nach Figur 6 basiert auf der Ausführungsform nach Figur 4. Sie enthält zusätzlich eine erste Kapazität $C_{VSS}$, die zwischen dem Gate des MOS-Transistors P2 und dem ersten Versorgungspotential VSS angeordnet ist. Dies hat den Vorteil, daß Störungen auf dem ersten Versorgungspotential VSS (meist gleich Null Volt, d.h. Masse), die unter ungünstigen Umständen das Schaltverhalten des Transistors N1 des ersten Inverters I1 negativ beeinflussen können (Einfluß auf Gate-Source-Spannung $U_{GS}$ dieses Transistors N1) durch die kapazitive Ankopplung des Referenzpotentials $V_{ref}$ an das erste Versorgungspotential VSS (und damit auf die Source des Transistors N1 des ersten Inverters I1) weitgehend unterbunden werden, da die kapazitive Ankopplung eine Reduzierung des Kanalstromes $I_{DS}$ im MOS-Transistor P2 bewirkt, die wiederum den Einfluß beim Transistor N1 des ersten Inverters I1 aufhebt. Die erste Kapazität $C_{VSS}$ ist insbesondere dann wichtig, wenn das Eingangssignal IN TTL-Pegel aufweist. Bei einem High-Pegel des Eingangssignales IN von 2.4 V ist nämlich der Transistor N1 des ersten Inverters I1 zwar elektrisch leitend (Versorgungspotentiale von VSS = 0 V und VDD = 5 V beispielhaft angenommen); seine Leitfähigkeit ist in diesem Bereich jedoch noch stark von eventuellen Störungen auf dem ersten Versorgungspotential VSS abhängig. Weist das Eingangssignal IN dagegen CMOS-Pegel auf, so kann die erste Kapazität $C_{VSS}$ durchaus entfallen, ohne die Funktion der Pufferschaltung zu beeinträchtigen, da dann das Schaltverhalten des Transistors N1 weitgehend unabhängig ist von Störungen des ersten Versorgungspotentials VSS. Es kann auch dann bei Eingangssignalen IN vom TTL-Pegel entfallen, wenn durch andere Maßnahmen sichergestellt ist, daß das erste Versorgungspotential VSS höchstens minimale Störungen aufweisen kann.

Die Weiterbildung nach Figur 7 zeigt über die Ausführungsform nach Figur 6 hinaus noch weitere vorteilhafte Maßnahmen, die den Betrieb einer erfindungsgemäßen Pufferschaltung optimieren. Zum einen ist eine zweite Kapazität $C_{IN}$ vorgesehen, die zwischen dem Gate des MOS-Transistors P2 und dem Eingang des ersten Inverters I1 angeordnet ist. Dies bewirkt eine kapazitive Kopplung zwischen dem Referenzpotential $V_{ref}$ und dem Eingangssignal IN und hat (bei aktiviertem Enable-Signal ØEN) kürzere Schaltzeiten des ersten Inverters I1 zur Folge als bei der Ausführungsform nach Figur 6.

Entweder eine der beiden Kapazitäten $C_{VSS}$, $C_{IN}$ oder beide Kapazitäten $C_{VSS}$, $C_{IN}$ können als MOS-Varaktoren ausgebildet sein, d. h. als Transistoren, deren Source und Drain miteinander elektrisch verbunden sind.

Sollte der erste Inverter I1 bezüglich seines Umschaltpunktes so dimensioniert sein, daß (bei aktiviertem Enable-Signal ØEN) an seinem Ausgang, d.h. am Schaltungsknoten 1, ein relativ langsamer Übergang vom High- in den Low-Zustand (oder umgekehrt) erfolgt, so hat dies bei Pegelwerten am Schaltungsknoten 1, die in der Nähe des Umschaltpunktes des zweiten Inverters I2 liegen, zur Folge, daß der zweite Inverter I2 kurzzeitig häufig zwischen Low und High (bzw. umgekehrt) hin- und herschaltet. Dies ist unerwünscht. Dieses unerwünschte Schaltverhalten kann auch auf Störungen am Eingangssignal IN und/oder beim ersten Versorgungspotential VSS beruhen.

In Figur 7 sind deshalb Hysteresetransistoren TNHy, TPHy vorgesehen. Der erste Hysteresetransistor TNHy ist mit seiner Kanalstrecke zwischen dem ersten Versorgungspotential VSS und dem Schaltungsknoten 1 angeordnet. Sein Gate ist mit dem Ausgang der Pufferschaltung verbunden. An ihm liegt also im Betrieb das Ausgangssignal OUT an. Er ist vom n-Kanal-Typ. Der zweite Hysteresetransistor TPHy ist mit seiner Kanalstrecke zwischen dem zweiten Versorgungspotential VDD und dem Schaltungsknoten 1 angeordnet. Das Gate ist ebenfalls mit dem Ausgang der Pufferschaltung verbunden. An ihm liegt also im Betrieb ebenfalls das Ausgangssignal OUT an. Er ist vom p-Kanal-Typ.

Dabei ist es vorteilhaft, wenn der Sättigungsstrom des ersten Hysteresetransistors TNHy kleiner ist als der Strom der Konstantstromquelle I (vorteilhafterweise: max. 30 % des Stromes der Konstantstromquelle I beträgt) und wenn das Verhältnis von Kanalweite zu Kanallänge (w/l) des zweiten Hysteresetransistors TPHy kleiner ist als das entsprechende Verhältnis von Kanalweite zu Kanallänge des Transistors N1 des ersten Inverters I1 (vorteilhafterweise: max. 30 % des Wertes beim Transistor N1 beträgt).

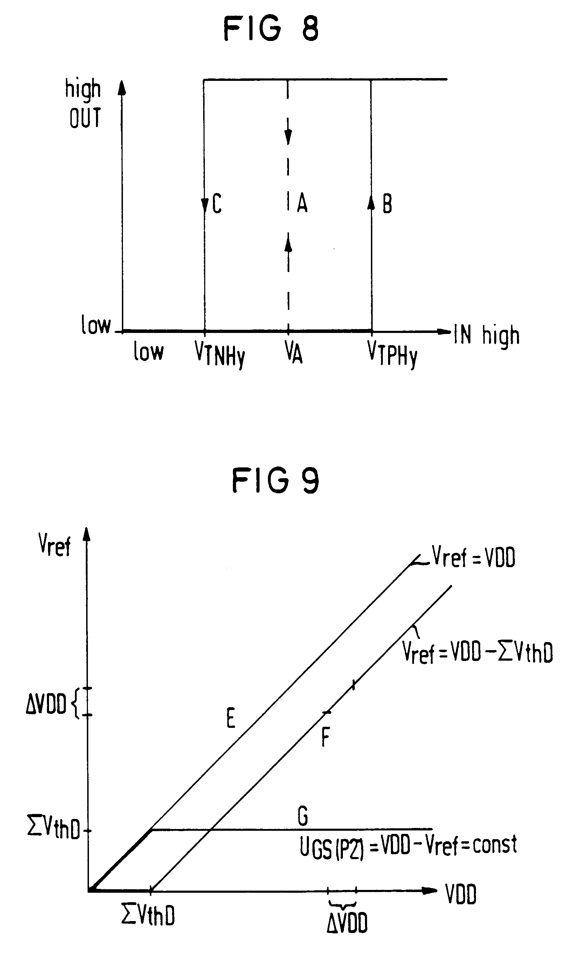

Nachstehend wird die Funktion der Hysteresetransistoren TNHy, TPHy anhand des Diagrammes nach Figur 8 beschrieben, wobei angenommen ist, daß das Enable-Signal ØEN seinen aktivierten, ersten logischen Pegel aufweist: In Figur 8 sind die Werte des Eingangssignals IN gegenüber den Werten des Ausgangssignales OUT der Pufferschaltung bezüglich verschiedener Ausführungsformen der Pufferschaltung als Kurven aufgetragen. Das Ansteigen und Abfallen des Eingangssignals IN ist jeweils mit einem Pfeil in den Kurven dargestellt.

Eine Kurve A (gestrichelt gezeichnet) zeigt das Schaltverhalten einer erfindungsgemäßen Pufferschaltung ohne Hysteresetransistoren TPHy, TNHy. Die Umschaltpunkte der Pufferschaltung für die Übergänge von Low auf High und von High auf Low des Ausgangssignales OUT liegen beide bei einem Wert $V_A$ des Eingangssignals IN.

Wenn derart große Störungen an den Versorgungspotentialen VSS, VDD und/oder am Eingangssignal IN zu erwarten sind, daß sie einen unerwünschten Übergang des Ausgangssignals OUT vom Low- in den High-Zustand zur Folge haben können (wobei angenommen ist, daß diese Störungen zeitlich nicht vorhersehbar sind, so daß dem Enable-Signal ØEN nicht der deaktivierte zweite logische Pegel zuordenbar ist), so empfiehlt es sich, den zweiten Hysteresetransistor TPHy nach Figur 8 vorzusehen (Kurven A und B). Dies bewirkt, daß bei Ansteigen des Eingangssignals IN das Ausgangssignal OUT seinen High-Wert erst bei einem Wert von $V_{TPHy}$ (Kurve B) des Eingangssignals IN annimmt, der höher ist als der Wert $V_A$ des Eingangssignals IN einer Pufferschaltung ohne diesen Hysteresetransistor (beispielsweise 0,1 bis 0,4 V höher). Für ein Ansteigen des Wertes des Eingangssignales IN (Pfeil in Kurve B) wird also der Umschaltpunkt der Pufferschaltung in Richtung größere Werte des Eingangsignals IN verschoben. Für ein Abfallen des Wertes des Eingangssignals IN (Pfeil nach unten in Kurve A) von High in Richtung Low bleibt der Umschaltpunkt der Pufferschaltung unverändert beim Wert $V_A$ des Eingangssignals IN (entsprechend einer Pufferschaltung ohne Hysteresetransistoren).

Wenn hingegen (ebenfalls zeitlich nicht vorhersehbar, s.o.) derart große Störungen an den Versorgungspotentialen VSS, VDD und/oder am Eingangssignal IN zu erwarten sind, daß sie einen unerwünschten Übergang des Ausgangssignales OUT vom High- in den Low-Zustand zur Folge haben können, so empfiehlt es sich, den ersten Hysteresetransistor TNHy vorzusehen (Kurven A und C). Dies bewirkt, daß bei Ansteigen des Eingangssignals IN das Ausgangssignal OUT seinen High-Wert unverändert beim Wert $V_A$ (Pfeil nach oben in Kurve A; entspricht einer Pufferschaltung ohne Hysteresetransistoren) des Eingangssignals IN annimmt. Für ein Abfallen des Wertes des Eingangssignals IN (Pfeil nach unten in Kurve C) von High in Richtung Low wird der Umschaltpunkt der Pufferschaltung jedoch auf einen Wert $V_{TNHy}$ in Richtung kleinere Werte des Eingangssignals IN verschoben (beispielsweise um 0,1 bis 0,4 V nach unten).

Sind jedoch entsprechende Störungen zu erwarten, die unerwünschte Übergänge des Ausgangssignals OUT sowohl beim Übergang vom High- in den Low-Zustand wie auch umgekehrt zur Folge haben können, so ist der Einsatz beider Hysteresetransistoren TPHy, TNHy vorteilhaft, wie in Figur 7 dargestellt (Kurven B und C in Figur 8). Dies bewirkt, daß bei Ansteigen des Eingangssignals IN das Ausgangssignal OUT seinen High-Wert erst bei dem Wert vom $V_{TPHy}$ (Kurve B) des Eingangssignals IN annimmt, der höher ist als der Wert $V_A$ des Eingangssignals IN einer Pufferschaltung ohne Hysteresetransistoren (beispielsweise 0,1 bis 0,4 V höher). Für ein Ansteigen des Wertes des Eingangssignals IN (Pfeil in Kurve B) wird also der Umschaltpunkt der Pufferschaltung in Richtung größere Werte des Eingangssignals IN verschoben. Ebenso wird bei einem Abfallen des Wertes des Eingangssignales IN (Pfeil nach unten in Kurve C) von High in Richtung Low der Umschaltpunkt der Pufferschaltung auf den Wert $V_{TNHy}$ in Richtung kleinere Werte des Eingangssignals IN verschoben gegenüber einer Pufferschaltung ohne Hysteresetransistoren (beispielsweise um 0,1 bis 0,4 V nach unten).

Figur 9 zeigt den Wert des Referenzpotentials $V_{ref}$ der Pufferschaltungen für Dioden D nach den Figuren 3 bis 6, aufgetragen gegenüber dem zweiten Versorgungspotential VDD (Kurve F). Sein Verlauf ist bei den Ausführungsformen nach den Figuren 2 und 7 qualitativ identisch, er ist lediglich in seinem quantitativen Verlauf gegebenenfalls unterschiedlich, da in den Ausführungsformen nach den Figuren 2, 7 keine Dioden gezeigt sind.

Eine Kurve E zeigt den hypothetischen Verlauf eines Referenzpotentials $v'_{ref}$, der sich ergäbe für eine Bedingung $v'_{ref}=$ VDD. Dieser Fall ist nach der vorliegenden Lehre tatsächlich ausgeschlossen, denn die Pufferschaltung würde nicht funktionieren, da der MOS-Transistor P2 stets im gesperrten Zustand wäre. Die Kurve E dient lediglich dazu, den Verlauf der Kurve F anschaulicher darstellen zu können: Kurve F zeigt den tatsächlichen Verlauf des Referenzpotentials $V_{ref}$ gegenüber dem zweiten Versorgungspotential VDD.

Zunächst steigt (bei Inbetriebnahme der Pufferschaltung und aktiviertem Enable-Signal ØEN) das zweite Versorgungspotential VDD an bis zu einem Wert, der der Summe $\Sigma V_{thD}$ aller Flußspannungen der Dioden D entspricht. Bis zu diesem Punkt beträgt der Wert des Referenzpotentials $V_{ref}$ stets 0 V. Die Gate-Source-Spannung $U_{GS(P2)}$ am MOS-Transistor P2 (dargestellt in Kurve G) steigt, parallel zum Ansteigen des zweiten Versorgungspotentials VDD, an bis zum Wert $\Sigma V_{thD}$. Wenn nun im weiteren Verlauf der Wert des zweiten Versorgungspotentials VDD diesen Summenwert $\Sigma V_{thD}$ übersteigt, so steigt das Referenzpotential $V_{ref}$ an mit einem Wert, der stets gleich ist dem jeweils aktuellen Wert des zweiten Versorgungspotentials VDD abzüglich des Summenwertes $\Sigma V_{thD}$, so daß stets gilt: $V_{ref} = VDD-\Sigma V_{thD}$. Demzufolge gilt für diesen Bereich für die Gate-Source-Spannung $U_{GS(P2)}$ am MOS-Transistor P2 stets die Gleichung

$$U_{GS(P2)} = VDD - V_{ref} = VDD - (VDD - \Sigma V_{thD}) = \Sigma V_{thD}.$$

Dieser Wert ist konstant. Wenn nun, wie erfindungsgemäß vorgesehen, der Summenwert $\Sigma V_{thD} \geq$ dem Wert der Einsatzspannung $V_{thP2}$ des MOS-Transistors P2 ist, so fließt über die Kanalstrecke des MOS-Transistors P2 stets ein konstanter Strom $I_{DS}$; der MOS-Transistor P2 wirkt als Konstantstromquelle I.

Figur 9 zeigt auch, daß sich in dem Fall, indem sich der Wert des zweiten Versorgungspotentials VDD um einen Betrag $\Delta VDD$ ändert (z. B. durch einen Spannungseinbruch oder, wie dargestellt, beim Anstieg des zweiten Versorgungspotentials VDD), der Wert des Referenzpotentials $V_{ref}$ um denselben Betrag $\Delta VDD$ ändert.

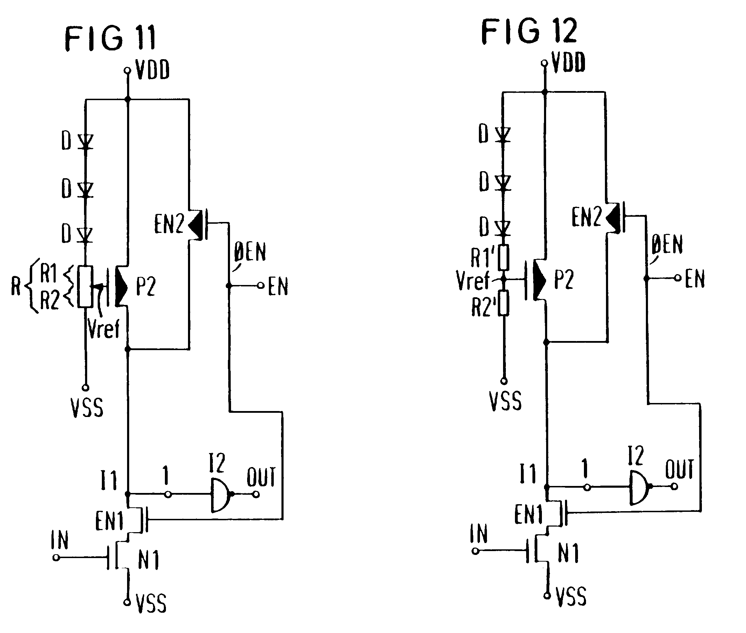

Figur 11 zeigt eine weitere, vorteilhafte Ausführungsform der erfindungsgemäßen Pufferschaltung. Sie basiert auf der Ausführungsform nach Figur 3 mit folgenden Änderungen: Zum einen sind die beiden Enable-Transistoren EN1, EN2 vom zueinander entgegengesetzten Kanaltyp, wie bereits anhand von Figur 1 beschrieben. Zum anderen ist der Widerstand R nicht zwischen dem Gate des MOS-Transistors P2 und dem ersten Versorgungspotential VSS angeordnet (wie bei Figur 3), sondern zwischen den Dioden D und dem ersten Versorgungspotential VSS. Der Widerstand R ist nach Art eines Potentiometers ausgestaltet mit einem Widerstandsabgriff, der mit dem Gate des MOS-Transistors P2 verbunden ist. Der Widerstand R zerfällt somit funktionell in zwei Widerstandsanteile R1, R2. Der erste Widerstandsanteil R1 ist dabei zwischen den Dioden und dem mit dem Gate des MOS-Transistors P2 verbundenen Widerstandsabgriff angeordnet, während der zweite Widerstandsanteil R2 zwischen diesem Widerstandsabgriff und dem ersten Versorgungspotential VSS angeordnet ist.

Mit dieser Anordnung läßt sich durch geeignetes Positionieren des Widerstandsabgriffes am Widerstand R der gewünschte Wert des Referenzpotentials $V_{ref}$ genauer einstellen als allein durch Auswählen einer geeigneten Anzahl von Dioden D mit ihren Diodenflußspannungen $V_{thD}$.

Eine technisch gleichwertige Lösung ergibt sich auch, wenn man anstelle des Widerstandes R mit seinen beiden Widerstandsanteilen R1, R2 wenigstens zwei separate, in Serie geschaltete Widerstände R1', R2' vorsieht, wobei der eine Widerstand R1' zwischen den Dioden D und dem Gate des MOS-Transistors P2 angeordnet ist, während der andere Widerstand R2' zwischen dem Gate des MOS-Transistors P2 und dem ersten Versorgungspotential VSS angeordnet ist (siehe Figur 12).

**Patentansprüche**

1. Integrierte Pufferschaltung mit einem ersten Inverter (I1) und wenigstens einer Konstantstromquelle (I), und mit folgenden Merkmalen:

   - Sie enthält wenigstens einen zweiten Inverter (I2), der in Serie zum ersten Inverter (I1) geschaltet ist, wobei ein Eingang des ersten Inverters (I1) mit einem Eingangssignal (IN) beaufschlagbar ist, wobei ein Ausgang des zweiten Inverters (I2) für ein Ausgangssignal (OUT) der Pufferschaltung vorgesehen ist und wobei zwischen den beiden Invertern (I1, I2) ein Schaltungsknoten (1) angeordnet ist,
   - der erste Inverter (I1) enthält die wenigstens eine Konstantstromquelle (I) und in Serie dazu einen Transistor (N1),
   - das Gate des Transistors (N1) ist der Eingang des ersten Inverters (I1),
   - die Source des Transistors (N1) des ersten Inverters (I1) ist mit einem ersten Versorgungspotential (VSS) verbunden,
   - die Drain des Transistors (N1) des ersten Inverters (I1) ist mit der Konstantstromquelle (I) verbindbar,
   - die Verbindung der Drain des Transistors (N1) des ersten Inverters (I1) mit der Konstantstromquelle (I) erfolgt mittels des stromführenden Pfades eines ersten Enable-Transistors (EN1), der elektrisch zwischen dem Transistor (N1) des ersten Inverters (I1) und dem Schaltungsknoten (1) angeordnet ist,
   - parallel zur Konstantstromquelle (I) ist ein zweiter Enable-Transistor (EN2) mit seinem stromführenden Pfad angeordnet,
   - die Gates der Enable-Transistoren (EN1, EN2) sind mit einem Enable-Eingang (EN) der Pufferschaltung verbunden,
   - zwischen dem Schaltungsknoten (1) und dem ersten Versorgungspotential (VSS) ist ein erster Hysteresetransistor (TNHy) mit seiner Kanalstrecke angeordnet, dessen Gate mit dem Ausgang des zweiten Inverters (I2) verbunden ist.

2. Integrierte Pufferschaltung nach Anspruch 1,
   **dadruch gekennzeichnet,** daß die Konstantstromquelle (I) einen MOS-Transistor (P2) enthält, der zwischen dem Schaltungsknoten (1) und einem zweiten Versorgungspotential (VDD) angeordnet ist, der im Betrieb elektrisch leitend ist und an dessen Gate im Betrieb ein Referenzpotential ($V_{ref}$) anliegt mit einem Wert, der eine konstante Differenz zum Wert des zweiten Versorgungspotentials (VDD) aufweist.

3. Integrierte Pufferschaltung nach Anspruch 2,
   **dadruch gekennzeichnet,** daß der MOS-Transistor (P2) vom p-Kanal-Typ ist.

4. Integrierte Pufferschaltung nach Anspruch 2 oder 3,
   **dadruch gekennzeichnet,** daß zur Erzeugung des Referenzpotentials ($V_{ref}$) wenigstens ein Widerstand (R) und wenigstens eine Diode (D) vorgesehen sind, daß die wenigstens eine Diode (D) zwischen dem Gate des MOS-Transistors (P2) und dem zweiten Versorgungspotential (VDD) angeordnet ist und daß der Widerstand (R) zwischen dem Gate des MOS-Transistors (P2) und dem ersten Versorgungspotential (VSS) angeordnet ist.

5. Integrierte Pufferschaltung nach Anspruch 2 oder 3,
   **dadurch gekennzeichnet,**

   - daß zur Erzeugung des Referenzpotentials ($V_{ref}$) wenigstens ein Widerstand (R) nach Art eines Potentiometers und wenigstens eine Diode (D) vorgesehen sind, wobei der Widerstand (R) einen ersten Widerstandsanteil (R1) und einen zweiten Widerstandsanteil (R2) aufweist,
   - daß beide Widerstandsanteile (R1, R2) an ihrem dem jeweiligen anderen Widerstandsanteil (R2; R1) zugewandten Ende mit dem Gate des MOS-Transistors (P2) verbunden sind als Potentialabgriff vom Widerstand (R),
   - daß die wenigstens eine Diode (D) zwischen dem ersten Widerstandsanteil (R1) und dem zweiten Versorgungspotential (VDD) angeordnet ist und
   - daß der zweite Widerstandsanteil (R2) mit dem ersten Versorgungspotential (VSS) verbunden ist.

6. Integrierte Pufferschaltung nach Anspruch 2 oder 3,
   **dadurch gekennzeichnet**,

   - daß zur Erzeugung des Referenzpotentials ($V_{ref}$) wenigstens zwei Widerstände (R1', R2') und wenigstens eine Diode (D) vorgesehen sind,
   - daß beide Widerstände (R1', R2') an ihrem dem jeweiligen anderen Widerstand (R2'; R1') zugewandten Ende mit dem Gate des MOS-Transistors (P2) verbunden sind,
   - daß die wenigstens eine Diode (D) zwischen dem ersten Widerstand (R1') und dem zweiten Versorgungspotential (VDD) angeordnet ist und
   - daß der zweite Widerstand (R2') mit dem ersten Versorgungspotential (VSS) verbunden ist.

7. Integrierte Pufferschaltung nach einem der Ansprüche 4 bis 6, **dadurch gekennzeichnet**, daß die Diode (D) eine pn-Übergangsdiode ist.

8. Integrierte Pufferschaltung nach einem der Ansprüche 4 bis 6, **dadurch gekennzeichnet**, daß die Diode (D) ein als Diode geschalteter Transistor ist.

9. Integrierte Pufferschaltung nach einem der Ansprüche 2 bis 8, **dadurch gekennzeichnet**, daß zwischen dem Gate des MOS-Transistors (P2) und dem ersten Versorgungspotential (VSS) eine erste Kapazität ($C_{VSS}$) angeordnet ist.

10. Integrierte Pufferschaltung nach einem der Ansprüche 2 bis 9, **dadurch gekennzeichnet**, daß zwischen dem Eingang des ersten Inverters (I1) und dem Gate des MOS-Transistors (P2) eine zweite Kapazität ($C_{IN}$) angeordnet ist.

11. Integrierte Pufferschaltung nach Anspruch 9 oder 10,
    **dadurch gekennzeichnet**, daß
    wenigstens eine der Kapazitäten ($C_{VSS}$, $C_{IN}$) ein MOS-Varaktor ist.

12. Integrierte Pufferschaltung nach einem des vorstehenden Ansprüche,
    **dadurch gekennzeichnet**, daß der
    erste Hysteresetransistor (TNHy) vom n-Kanal-Typ ist.

13. Integrierte Pufferschaltung nach einem des vorstehenden Ansprüche,
    **dadurch gekennzeichnet**, daß der
    erste Hysteresetransistor (TNHy) einen Sättigungsstrom aufweist, der kleiner ist als der Strom der Konstantstromquelle (I).

14. Integrierte Pufferschaltung nach einem der vorstehenden Ansprüchen,
    **dadurch gekennzeichnet**,
    daß zwischen dem Schaltungsknoten (1) und dem zweiten Versorgungspotential (VDD) ein zweiter Hysteresetransistor (TPHy) mit seiner Kanalstrecke angeordnet ist, dessen Gate mit dem Ausgang des zweiten Inverters (I2) verbunden ist.

15. Integrierte Pufferschaltung nach Anspruch 14,
    **dadurch gekennzeichnet,** daß der
    zweite Hysteresetransistor (TPHy) vom p-Kanal-Typ ist.

16. Integrierte Pufferschaltung nach Anspruch 14 oder 15,
    **dadurch gekennzeichnet,** daß der
    zweite Hysteresetransistor (TPHy) ein Verhältnis von Kanalweite zu Kanallänge aufweist, das kleiner ist als das
    Verhältnis von Kanalweite zu Kanallänge des Transistors (N1) des ersten Inverters (I1).

17. Integrierte Pufferschaltung nach einem der vorstehenden Ansprüche,
    **dadurch gekennzeichnet,**
    daß die Enable-Transistoren (EN1, EN2) vom zueinander entgegengesetzten Kanaltyp sind.

18. Integrierte Pufferschaltung nach einem der Ansprüche 1 bis 16, **dadurch gekennzeichnet,**
    daß die Enable-Transistoren (EN1, EN2) vom selben Kanaltyp sind und daß zwischen dem Enable-Eingang (EN)
    und dem Gate eines (EN2; EN1) der beiden Enable-Transistoren (EN1, EN2) ein dritter Inverter (13) angeordnet ist.

## Claims

1. Integrated buffer circuit having a first inverter (I1) and at least one constant current source (I), and having the
   following features:

   - it contains at least one second inverter (I2), which is connected in series with the first inverter (I1), it being
     possible to apply an input signal (IN) to an input of the first inverter (I1), an output of the second inverter (I2)
     being provided for an output signal (OUT) of the buffer circuit, and a circuit node (1) being arranged between
     the two inverters (I1, I2),
   - the first inverter (I1) contains the at least one constant current source (I) and a transistor (N1) in series therewith,
   - the gate of the transistor (N1) is the input of the first inverter (I1),
   - the source of the transistor (N1) of the first inverter (I1) is connected to a first supply potential (VSS),
   - the drain of the transistor (N1) of the first inverter (I1) can be connected to the constant current source (I),
   - the connection of the drain of the transistor (N1) of the first inverter (I1) to the constant current source (I) is
     performed by means of the current-carrying path of a first enable transistor (EN1) which is arranged electrically
     between the transistor (N1) of the first inverter (I1) and the circuit node (1),
   - a second enable transistor (EN2) is arranged with its current-carrying path in parallel with the constant current
     source (I),
   - the gates of the enable transistors (EN1, EN2) are connected to an enable input (EN) of the buffer circuit, and
   - a first hysteresis transistor (TNHy) whose gate is connected to the output of the second inverter (I2) is arranged
     with its channel path between the circuit node (1) and the first supply potential (VSS).

2. Integrated buffer circuit according to Claim 1, characterized in that the constant current source (I) contains a MOS
   transistor (P2) which is arranged between the circuit node (1) and a second supply potential (VDD) and is electrically
   conductive during operation and at whose gate a reference potential ($V_{ref}$) is present during operation with a value
   which has a constant difference from the value of the second supply potential (VDD).

3. Integrated buffer circuit according to Claim 3, characterized in that the MOS transistor (P2) is of the p-channel type.

4. Integrated buffer circuit according to Claim 2 or 3, characterized in that at least one resistor (R) and at least one
   diode (D) are provided for the purpose of generating the reference potential ($V_{ref}$), in that the at least one diode
   (D) is arranged between the gate of the MOS transistor (P2) and the second supply potential (VDD), and in that
   the resistor (R) is arranged between the gate of the MOS transistor (P2) and the first supply potential (VSS).

5. Integrated buffer circuit according to Claim 2 or 3, characterized in that

   - at least one resistor (R) of the type of a potentiometer and at least one diode (D) are provided for the purpose of generating the reference potential ($V_{ref}$), the resistor (R) having a first resistor part (R1) and a second resistor part (R2),

- in that at their end facing the respective other resistor part (R2; R1) the two resistor parts (R1, R2) are connected to the gate of the MOS transistor (P2) as a potential tap of the resistor (R),
- in that the at least one diode (D) is arranged between the first resistor part (R1) and the second supply potential (VDD), and
- in that the second resistor part (R2) is connected to the first supply potential (VSS).

6. Integrated buffer circuit according to Claim 2 or 3, characterized in that

- at least two resistors (R1', R2') and at least one diode (D) are provided for generating the reference potential ($V_{ref}$),
- at their end facing the respective other resistor (R2'; R1') the two resistors (R1', R2') are connected to the gate of the MOS transistor (P2),
- in that the at least one diode (D) is arranged between the first resistor (R1') and the second supply potential (VDD), and
- in that the second resistor (R2') is connected to the first supply potential (VSS).

7. Integrated buffer circuit according to one of Claims 4 to 6, characterized in that the diode (D) is a pn junction diode.

8. Integrated buffer circuit according to one of Claims 4 to 6, characterized in that the diode (D) is a transistor connected as a diode.

9. Integrated buffer circuit according to one of Claims 2 to 8, characterized in that a first capacitor ($C_{VSS}$) is arranged between the gate of the MOS transistor (P2) and the first supply potential (VSS).

10. Integrated buffer circuit according to one of Claims 2 to 9, characterized in that a second capacitor ($C_{IN}$) is arranged between the input of the first inverter (I1) and the gate of the MOS transistor (P2).

11. Integrated buffer circuit according to Claim 9 or 10, characterized in that at least one of the capacitors ($C_{VSS}$, $C_{IN}$) is a MOS varactor.

12. Integrated buffer circuit according to one of the preceding claims, characterized in that the first hysteresis transistor (TNHy) is of the n-channel type.

13. Integrated buffer circuit according to one of the preceding claims, characterized in that the first hysteresis transistor (TNHy) has a saturation current which is smaller than the current of the constant current source (I).

14. Integrated buffer circuit according to one of the preceding claims, characterized in that a second hysteresis transistor (TPHy) whose gate is connected to the output of the second inverter (I2) is arranged with its channel path between the circuit node (1) and the second supply potential (VDD).

15. Integrated buffer circuit according to Claim 14, characterized in that the second hysteresis transistor (TPHy) is of the p-channel type.

16. Integrated buffer circuit according to Claim 14 or 15, characterized in that the second hysteresis transistor (TPHy) has a ratio of channel width to channel length which is smaller than the ratio of channel width to channel length of the transistor (N1) of the first inverter (I1).

17. Integrated buffer circuit according to one of the preceding claims, characterized in that the enable transistors (EN1, EN2) are of mutually opposite channel types.

18. Integrated buffer circuit according to one of Claims 1 to 16, characterized in that the enable transistors (EN1, EN2) are of the same channel type, and in that a third inverter (I3) is arranged between the enable input (EN) and the gate of one (EN2; EN1) of the two enable transistors (EN1, EN2).

**Revendications**

1. Circuit tampon intégré comportant un premier inverseur (I1), et au moins une source (I) de courant constant et ayant les caractéristiques suivantes:

   - il comprend au moins un second inverseur (I2), qui est branché en série avec le premier inverseur (I1), un signal (IN) d'entrée pouvant être appliqué à une entrée du premier inverseur (I1), une sortie du second inverseur (I2) pour un signal (OUT) de sortie du circuit tampon étant prévue et un noeud (1 de circuit se trouvant entre les deux inverseurs (I1, (I2),
   - le premier inverseur (I1) comprend la au moins une source (I) de courant constant et en série avec celle-ci un transistor (N1),
   - la grille du transistor (N1) est l'entrée du premier inverseur (I1),
   - la source du transistor (N1) du premier inverseur (I1) est reliée à un premier potentiel (VSS) d'alimentation,
   - le drain du transistor (N1) du premier inverseur (I1) peut être relié à la source (I) de courant constant,
   - la liaison du drain du transistor (N1) du premier inverseur (I1) avec la source (I) de courant constant s'effectue au moyen de la voie conductrice de courant d'un premier transistor (EN1) de validation, qui est disposé entre le transistor (N1) du premier inverseur (I1) et le noeud (1) du circuit,
   - il est disposé en parallèle avec la source (I) de courant constant, la voie conductrice de courant d'un second transistor (EN2) de validation,
   - les grilles des transistors (EN1, EN2) de validation sont reliées à une entrée (EN) de validation du circuit tampon,
   - un premier transistor (TNHy) d'hystérésis est disposé par sa voie de canal entre le noeud (1) du circuit et le premier potentiel (VSS) d'alimentation, la grille de ce transistor (TNHy) d'hystérésis étant reliée à la sortie du second inverseur (I2).

2. Circuit tampon intégré suivant la revendication 1,
   caractérisé en ce que la source (I) de courant constant comprend un transistor MOS (P2), qui est disposé entre le noeud (1) du circuit et un second potentiel (VDD) d'alimentation, qui conduit en fonctionnement et à la grille duquel est appliqué en fonctionnement un potentiel ($V_{ref}$) de référence ayant une valeur qui a une différence constante par rapport à la valeur du second potentiel (VDD) d'alimentation.

3. Circuit tampon intégré suivant la revendication 2,
   caractérisé en ce que le transistor MOS (P2) est du type à canal p.

4. Circuit tampon intégré suivant la revendication 2 ou 3,
   caractérisé en ce qu'il est prévu pour produire le potentiel ($V_{ref}$) de référence au moins une résistance (R) et au moins une diode (D), la au moins une diode (D) est disposée entre la grille du transistor MOS (P2) et le second potentiel (VDD) d'alimentation, et la résistance (R) est disposée entre la grille du transistor MOS (P2) et le premier potentiel (VSS) d'alimentation.

5. Circuit tampon intégré suivant la revendication 2 ou 3,
   caractérisé en ce que

   - il est prévu pour produire le potentiel ($V_{ref}$) de référence au moins une résistance (R) conçue à la manière d'un potentiomètre et au moins d'une diode (D), la résistance (R) ayant une première partie (R1) de résistance et une seconde partie (R2) de résistance,
   - les deux parties (R1, R2) de résistance sont reliées, à leur extrémité tournée vers l'autre partie respective de résistance (R2; R1) à la grille du transistor MOS (P2), en tant que prise de potentiel de la résistance (R),
   - la au moins une diode (D) est disposée entre la première partie (R1) de résistance et le second potentiel (VDD) d'alimentation et
   - la seconde partie (R2) de résistance est reliée au premier potentiel (VSS) d'alimentation.

6. Circuit tampon intégré suivant la revendication 2 ou 3,
   caractérisé en ce que

   - il est prévu pour produire le potentiel ($V_{ref}$) de référence au moins deux résistances (R1', R2') et au moins une diode (D),
   - les deux résistances (R1', R2') sont reliées par leur extrémité tournée vers l'autre résistance respective (R2';

R1") à la grille du transistor MOS (P2),

- la au moins une diode (D) est disposée entre la première résistance (R1') et le second potentiel (VDD) d'alimentation et

- la seconde résistance (R2') est reliée au premier potentiel (VSS) d'alimentation.

7. Circuit tampon intégré suivant l'une des revendications 4 à 6, caractérisé en ce que la diode (D) est une diode à jonction pn.

8. Circuit tampon intégré suivant l'une des revendications 4 à 6, caractérisé en ce que la diode (D) est un transistor branché en diode.

9. Circuit tampon intégré suivant l'une des revendications 2 à 8, caractérisé en ce que il est disposé entre la grille du transistor MOS (P2) et le premier potentiel (VSS) d'alimentation d'une première capacité ($C_{VSS}$).

10. Circuit tampon intégré suivant l'une des revendications 2 à 9, caractérisé en ce que
il est disposé entre l'entrée du premier inverseur (I1) et la grille du transistor MOS (P2) une seconde capacité ($C_{IN}$).

11. Circuit tampon intégré suivant la revendication 9 ou 10,
caractérisé en ce que
au moins l'une des capacités ($C_{VSS}$, $C_{IN}$) est un varactor MOS.

12. Circuit tampon intégré suivant l'une des revendications précédentes,
caractérisé en ce que
le premier transistor (TNHY) d'hystérésis est du type à canal n.

13. Circuit tampon intégré suivant l'une des revendications précédentes,
caractérisé en ce que
le premier transistor (TNHy) d'hystérésis a un courant de saturation qui est plus petit que le courant de la source (I) de courant constant.

14. Circuit tampon intégré suivant l'une des revendications précédentes,
caractérisé en ce que
il est disposé entre le noeud (1) du circuit et le second potentiel (VDD) d'alimentation, la voie de canal d'un second transistor (TPHy) d'hystérésis, dont la grille est reliée à la sortie du second inverseur (I2).

15. Circuit tampon intégré suivant la revendication 14,
caractérisé en ce que le second transistor (TPHy) d'hystérésis est du type à canal p.

16. Circuit tampon intégré suivant la revendication 14 ou 15,
caractérisé en ce que le second transistor (TPHY) d'hystérésis a un rapport largeur de canal sur longueur de canal, qui est plus petit que le rapport largeur de canal sur longueur de canal du transistor (N1) du premier inverseur (I1).

17. Circuit tampon intégré suivant l'une des revendications précédentes,
caractérisé en ce que
les transistors (EN1, EN2) de validation ont un canal de type opposé.

18. Circuit tampon intégré suivant l'une des revendications 1 à 16,
caractérisé en ce que
les transistors (EN1, EN2) de validation sont du même type de canal et il est disposé entre l'entrée (EN) de validation et la grille de l'un (EN2; EN1) des deux transistors (EN1, EN2) de validation un troisième inverseur (I3).

# FIG 1

# FIG 2

**FIG 3**

**FIG 4**

**FIG 5**

13

FIG 7

FIG 6

# FIG 8

# FIG 9

# FIG 10

FIG 11

FIG 12

EP 0 587 937 B1